**Europäisches Patentamt**

(19) **European Patent Office**

**Office européen des brevets**

(11) Numéro de publication: **0 203 663**
**B1**

(12) **FASCICULE DE BREVET EUROPEEN**

(45) Date de publication du fascicule du brevet:
**12.09.90**

(51) Int. Cl.⁵: **H03B 5/18,** H03C 3/22

(21) Numéro de dépôt: **86200887.7**

(22) Date de dépôt: **22.05.86**

(54) Oscillateur hyperfréquence de puissance, modulé linéairement sur une grande plage de fréquence.

(30) Priorité: **28.05.85 FR 8507951**

(43) Date de publication de la demande:
**03.12.86 Bulletin 86/49**

(45) Mention de la délivrance du brevet:
**12.09.90 Bulletin 90/37**

(84) Etats contractants désignés:
**DE FR GB IT SE**

(56) Documents cités:
**US-A- 4 189 690**
**US-A- 4 310 809**

**PATENTS ABSTRACTS OF JAPAN,**
**vol. 9, no. 43 (E-298)[1766], 22 février 1985; & JP - A**
**- 59 183 507 (TOSHIBA K.K.) 18-10-1984**

(73) Titulaire: **TELECOMMUNICATIONS**
**RADIOELECTRIQUES ET TELEPHONIQUES T.R.T.,**
**88, rue Brillat Savarin, F-75013 Paris(FR)**
(84) Etats contractants désignés: **FR**

(73) Titulaire: **N.V. Philips' Gloeilampenfabrieken,**
**Groenewoudseweg 1, NL-5621 BA Eindhoven(NL)**
(84) Etats contractants désignés: **DE GB IT SE**

(72) Inventeur: **Rudelle, Marie-Irène Société Civile S.P.I.D.,**
**209 rue de l'Université, F-75007 Paris(FR)**

(74) Mandataire: **Chaffraix, Jean et al, Société Civile**
**S.P.I.D. 156, Boulevard Haussmann, F-75008 Paris(FR)**

**Description**

L'invention concerne un oscillateur hyperfréquence de puissance modulé linéairement sur une grande plage de fréquence autour d'une fréquence centrale au moyen de deux diodes à capacité variable en fonction d'une tension de commande et dont les cathodes sont reliées entre elles à travers un élément de ligne sur lequel est appliquée ladite tension de commande, ledit oscillateur comportant un transistor dont les impédances d'adaptation sur ses électrodes d'entrée et de sortie sont réalisées par des lignes calculées de façon à assurer un gain maximum à la fréquence centrale.

L'oscillateur de l'invention fournit une puissance de sortie de 600 mW à une fréquence de travail de l'ordre de 4 GHz et trouve une application dans des équipements tels que les sources de radioaltimètres ou de fusées de proximité pour lesquelles une extrême précision de la linéarité de la caractéristique fréquence-tension de commande est exigée.

Une telle linéarité est définie comme le rapport de la pente maximale de la caractéristique à la pente minimale dans la plage de variation de fréquence imposée (par exemple 200 MHz autour de 4 GHz).

Une autre définition de la linéarité par l'écart de fréquence par rapport à une variation linéaire théorique est plus avantageuse mais ne rend pas compte des brusques variations importantes de pente qui s'avèrent inadmissibles dans les applications précitées.

Le calcul a montré que pour une variation quasi sinusoïdale autour de la loi idéale, la linéarité donnée par la première définition est au moins 4 Π fois plus exigeante que celle fournie par la seconde, cette dernière définition étant celle que l'on rencontre le plus fréquemment dans la littérature.

Des oscillateurs hyperfréquence du genre mentionné dans le préambule de la revendication 1 sont connus par exemple du document US-A 4 310 809 ou du document US-A 4 189 690 qui décrivent un dispositif à résistance négative réalisé à partir d'un transistor bipolaire et dont la variation de fréquence est commandée par des varactors placés en parallèle dans le circuit de wobulation. Des oscillateurs de ce type, d'un usage courant dans le domaine des hyperfréquences, fournissent une puissance de sortie relativement faible qui est ici de 10 mW à 8,5 GHz. Par ailleurs la linéarité obtenue sur la modulation de fréquence basée uniquement sur les caractéristiques hyperabruptes des varactors ne satisfait pas aux conditions d'extrême précision définies ci-dessus.

Le but de l'invention est de réaliser à partir d'un transistor hyperfréquence à fort gain, un oscillateur du type à amplificateur bouclé fournissant une puissance élevée et présentant une extrême linéarité de la caractéristique de modulation de fréquence en fonction de la tension appliquée.

L'oscillateur de l'invention selon la revendication 1 est remarquable en ce que l'oscillation à la fréquence de travail est obtenue pour un mode de fonctionnement stable du transistor dans ladite plage de fréquence, au moyen d'un réseau de rebouclage renvoyant une partie du signal de sortie de l'oscillateur sur le signal d'entrée de ce dernier, lesdites diodes à capacité variable étant intercalées en série entre trois éléments de ligne dans un circuit de wobulation monté en parallèle sur ledit réseau de rebouclage, ledit élément de ligne reliant les cathodes entre elles constituant l'un des trois éléments, les deux autres éléments dont une extrémité est reliée à une anode de diode tant connectés respectivement par l'autre extrémité à point du réseau de rebouclage situé sur le circuit d'adaptation de l'entrée du transistor et à la masse, lesdits éléments de ligne du circuit de wobulation ayant des impédances élevées pour conserver au maximum la correction de phase introduite par les deux diodes à capacité variable.

Des transistors hyperfréquence à fort gain sont actuellement disponibles. L'utilisation dans l'oscillateur de l'invention d'un transistor hyperfréquence à effet de champ ayant un gain de l'ordre de 10 dB rend possible ledit rebouclage à partir d'un coupleur constitué de deux lignes relativement fines situées à proximité l'une de l'autre en sortie de l'oscillateur. Une faible partie de la puissance de sortie est ainsi prélevée par rayonnement et renvoyée sur l'entrée à travers un réseau comportant la ligne équivalente au coupleur et respectant la condition d'oscillation. Des transistors ayant des valeurs de gain plus faibles de l'ordre de 3 dB nécessiteraient des coupleurs dont les dimensions seraient prohibitives.

La description suivante en regard des dessins annexés, le tout donné à titre d'exemple, fera bien comprendre comment l'invention peut être réalisée.

La figure 1 représente le schéma de principe de l'oscillateur hyperfréquence conforme à l'invention.

La figure 2 illustre le fonctionnement du circuit de wobulation disposé en parallèle sur le réseau de rebouclage.

La figure 3 montre la vue d'ensemble d'une réalisation de l'oscillateur en technologie "micro-strip".

La figure 4 donne les variations de la fréquence de l'oscillateur et de la puissance qu'il fournit en fonction de la tension de commande.

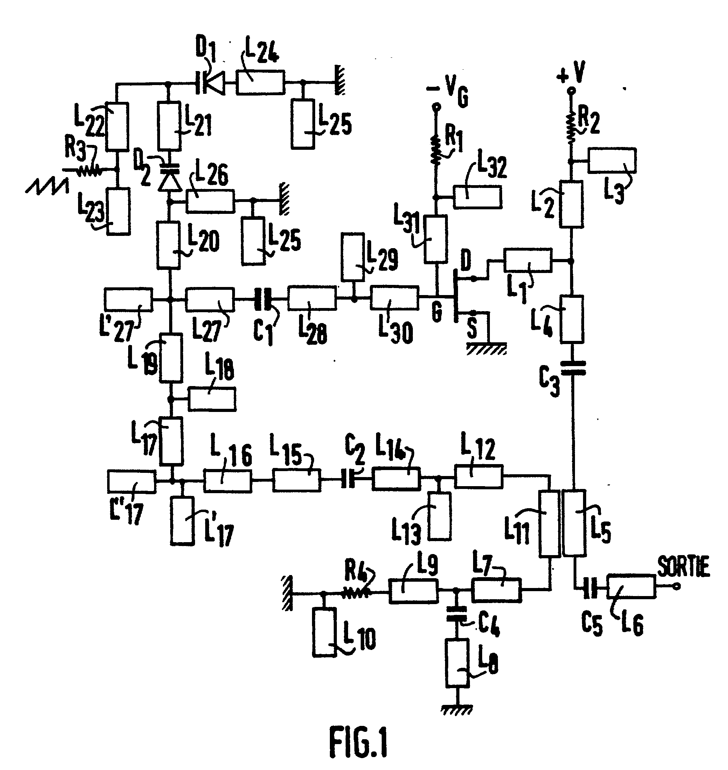

Les éléments correspondants sur les figures 1, 2 et 3 seront désignés par les mêmes signes de référence.

L'oscillateur hyperfréquence de l'invention dont le schéma est représenté sur la figure 1 est obtenu à partir d'un amplificateur bouclé comportant un transistor à effet de champ T monté en source commune S reliée directement à la masse.

L'adaptation à 50 $\Omega$ de l'impédance d'entrée de ce transistor est constituée par :
- la mise en série entre la masse et la grille G du transistor de la résistance $R_4$, des lignes $L_9$, $L_7$, $L_{11}$, $L_{12}$, $L_{14}$, du condensateur $C_2$, des lignes $L_{15}$, $L_{16}$, $L_{17}$, $L_{19}$, $L_{27}$, du condensateur $C_1$, des lignes $L_{28}$ et $L_{30}$ ;
- le montage en série du condensateur $C_4$ et de la ligne $L_8$ entre le point commun aux lignes $L_7$ et $L_9$ et la masse ;
- les lignes ouvertes à une extrémité (appelées stubs dans la littérature anglo-américaine) $L_{13}$, ($L'_{17}$, $L''_{17}$), $L_{18}$, $L'_{27}$ et $L_{29}$ disposées respectivement aux

interconnexions des lignes $L_{12}$ et $L_{14}$, $L_{16}$ et $L_{17}$, $L_{17}$ et $L_{19}$, $L_{19}$ et $L_{27}$, $L_{28}$ et $L_{30}$.

De même, l'adaptation à 50 Ω de l'impédance de sortie est constituée par la mise en série entre ladite sortie et la masse de la ligne $L_6$, du condensateur $C_5$, de la ligne $L_5$, du condensateur $C_3$, des lignes $L_4$ et $L_1$.

Les caractéristiques de l'amplificateur ainsi constitué sont les suivantes :
- Facteur de Linvill inférieur à l'unité (la condition de stabilité est donc remplie).
- Gain maximum $G_m$ entre grille et drain de l'ordre de 10 dB.
- Puissance de sortie maximum approchant 1 watt.

Les longueurs des lignes et des stubs ainsi que les capacités des condensateurs du circuit d'amplification sont définies de telle façon que :
- les impédances synthétisées de source $Z_S$ entre grille et masse et de charge $Z_L$ entre drain et masse assurent un gain maximum de l'amplificateur à la fréquence centrale.
- les modules des coefficients de réflexion d'entrée $\Gamma_1 =$

$$\frac{Z_1 - Z_0}{Z_1 + Z_0}$$

et de sortie $\Gamma_2 =$

$$\frac{Z_2 - Z_0}{Z_2 + Z_0}$$

soient élevés (proches de l'unité) et sensiblement indépendants de la fréquence dans la bande de fréquence utile ($Z_1$ et $Z_2$ étant respectivement les impédances d'entrée et de sortie et $Z_0 = 50$ Ω).
- la phase du coefficient de réflexion $\Gamma_1$ varie de façon monotone en fonction de la fréquence dans la bande de fréquence utile.
- le déphasage entre les tensions d'entrée et de sortie soit égal à 2 kΠ à la fréquence centrale et varie également de façon monotone en fonction de la fréquence.

Les impédances d'adaptation d'entrée et de sortie comportent respectivement les lignes $L_{11}$ et $L_5$ de même longueur et relativement fines. La mise à proximité de ces deux lignes constitue un coupleur directif qui assure le rebouclage de l'amplificateur sur lui-même. Le réseau de rebouclage ainsi constitué adapte la sortie du transistor à son entrée et ramène en un point quelconque la ligne équivalente au coupleur respectant la condition d'oscillation.

Du point de vue adaptation (influence sur le module et sur la phase d'un coefficient de réflexion) et du point de vue déphasage en tension entre ses bornes d'entrée et de sortie couplées, le coupleur directif de faible couplage (T 10 dB) de longueur l et d'impédance caractéristique $Z_C$ se comporte comme une ligne de longueur

$$1 + \frac{3\lambda}{4}$$

et d'impédance caractéristique $Z_C$, λ étant la longueur d'onde correspondant à la fréquence de l'oscillation.

La polarisation du drain est assurée par une source de tension continue V dont la borne négative est à la masse et la borne positive est reliée au point d'interconnexion des lignes $L_1$ et $L_4$ à travers une résistance $R_2$ et une ligne $L_2$, celle-ci étant munie d'un stub $L_3$.

La polarisation de la grille est assurée de la même manière par une source de tension continue $V_G$ dont la borne positive à la masse et dont la borne négative est reliée à la grille à travers une résistance $R_1$ et une ligne $L_{31}$, celle-ci étant munie d'un stub $L_{32}$.

Le circuit de wobulation disposé en parallèle sur le réseau de rebouclage est constitué de deux diodes à capacité variable ou varicaps $D_1$ et $D_2$ intercalées en série entre les éléments de ligne $L_{24}$, $L_{21}$ et $L_{20}$. L'élément central $L_{21}$ relie entre elles les cathodes des diodes et reçoit sur son extrémité reliée à $D_1$, à travers une résistance $R_3$ et une ligne $L_{22}$ munie d'un stub $L_{23}$, un signal de tension de commande variable en dents de scie. Les éléments de ligne $L_{20}$ et $L_{24}$ dont une extrémité est reliée à une anode de diode ont leurs autres extrémités reliées respectivement à l'interconnexion des lignes $L_{19}$, $L_{27}$, L'$_{27}$, du circuit d'adaptation d'entrée et à la masse.

Les lignes et stubs $L_{24}$ et $L_{25}$ d'une part, $L_{26}$ et $L_{25}$ d'autre part constituent respectivement les rappels de masse des anodes des varicaps $D_1$ et $D_2$.

La position de ce circuit de wobulation sur l'abaque de Smith et la longueur des trois éléments de ligne sont déterminées conformément à l'invention pour obtenir la linéarité de la fréquence en fonction de la tension de commande.

On va maintenant examiner les différentes façons de réaliser le circuit de wobulation dans le but d'aboutir à la meilleure linéarité possible et expliquer sommairement le processus d'optimisation de ladite linéarité à partir du circuit donné ci-dessus.

A deux fréquences différentes mais voisines, le réseau d'adaptation n'a pas la même influence sur l'impédance de sortie : si l'on part d'un même point de l'abaque de Smith, il introduit entre les deux coefficients de réflexion une différence de phase Δφ (Γ) et une différence de module Δ | Γ | . Cette dernière est négligeable, les modules des coefficients de réflexion d'entrée et de sortie étant du même ordre de grandeur et variant peu avec la fréquence. Le circuit de wobulation a pour rôle de compenser le Δφ(Γ) apporté par le réseau d'adaptation et de faire varier le déphasage en tension φ(V) ce qui permet de faire varier la fréquence d'oscillation.

Les coefficients de réflexion des impédances d'entrée et de sortie du transistor adapté varient peu avec la fréquence. On enregistre une différence de phase de l'ordre de 4° pour le coefficient de réflexion d'entrée comme pour celui de sortie.

La taille du transistor, la présence de la ligne équivalent au coupleur (pour laquelle seule la longueur a une influence différente suivant la fréquence) imposent une longueur de ligne dispersive de l'ordre de λ à la fréquence centrale. Cette dernière étant de 4 GHz, le déphasage correspondant à une modulation de 200 MHz sera :

$$2 \times 360 \times \frac{0,42}{4} = 36°.$$

(le coefficient 2 tient compte de la périodicité de 180° sur l'abaque de Smith).

Au total la variation de phase $\Delta\phi(\Gamma)$ à compenser à l'aide du circuit de wobulation est donc de l'ordre de 40°.

On remarque par ailleurs qu'une variation d'impédance réduite $\Delta z$ d'une varicap a un maximum d'influence sur $\Delta\phi(\Gamma)$ dans la zone de court-circuit de l'abaque de Smith.

Si l'impédance de la varicap est de 50 Ω à 4 GHz et si une modulation de 200 MHz autour de cette fréquence introduit une variation d'impédance de 20 Ω, la différence d'impédance réduite

$$z = \frac{\Delta Z}{Z} = -j0,4$$

entraîne une différence de phase du coefficient de réflexion de 40°. Il semble donc tout indiqué de réaliser simplement la compensation de phase du réseau de rebouclage au moyen d'une seule varicap montée en série dans ce réseau.

L'adaptation entrée-sortie ayant été réalisée en disposant des stubs sur les lignes nécessaires au rebouclage de manière à modifier le moins possible la variation du module du coefficient de réflexion en fonction de la fréquence, on peut alors ne s'intéresser qu'à la variation de phase $\Delta\phi(\Gamma)$ de ce coefficient qui est linéaire. Il en est de même de la variation de la partie imaginaire de l'impédance réduite $\Delta\mathrm{Im}(z)$.

Dans la zone où l'on souhaite placer la varicap, on veut donc compenser les variations linéaires en fonction de la fréquence de $\phi(\Gamma)$ et $\mathrm{Im}(z)$ apportées par le réseau de rebouclage au moyen d'une variation linéaire en sens inverse de $\phi_v(\Gamma)$ et $\mathrm{Im}_v(z)$ de la varicap. Cela implique que la cacactéristique $\phi_v(\Gamma)$ en fonction de $\mathrm{Im}_v(z)$ est linéaire. Si on se place effectivement dans une zone linéaire de cette caractéristique obtenue expérimentalement, la variation de l'impédance de la varicap en fonction de la fréquence devrait être également linéaire. Or la variation expérimentale montre qu'elle ne l'est pas et accuse une non-linéarité importante de l'ordre de 40 %. L'examen de cette variation d'impédance avec la tension révèle de plus que la pente de wobulation est élevée : 200 MHz pour 12,4 V.

On peut essayer de compenser cette non-linéarité en plaçant la varicap en un autre point de l'abaque de Smith où le déphasage du coefficient de réflexion ne varie plus linéairement avec la partie imaginaire de l'impédance réduite. Dans ce cas la linéarité se trouve améliorée mais la variation de phase apportée par la varicap diminue : il faudra augmenter la pente de wobulation qui était déjà élevée. L'expérience a montré qu'il faudrait à peu près la doubler.

Le moyen de pallier cet inconvénient consiste à placer la varicap en parallèle sur le réseau de rebouclage.

C'est en amenant la variation d'admittance $\Delta y$ de la varicap à agir dans la région de circuit ouvert (en impédance) qu'on obtiendra une variation maximale de la phase du coefficient de réflexion et une variation minimale de son module ainsi qu'on peut le vérifier en se référant à l'abaque de Smith. La position du circuit de wobulation parallèle est ainsi bien définie dans le circuit de rebouclage.

Comme dans le cas précédent où la varicap était en série dans le réseau de rebouclage, on veut compenser une variation linéaire en fonction de la fréquence du $\Delta\phi(\Gamma)$ apporté par le réseau d'adaptation par une variation linéaire en sens inverse du $\Delta\phi_v(\Gamma)$ apporté par la varicap. Le circuit parallèle associé à la varicap doit donc amener la variation d'admittance $\Delta y_v$ de celle-ci à agir dans une zone où la non-linéarité de la courbe de variation de la phase du coefficient de réflexion en fonction de la partie imaginaire de l'admittance réduite compense la non-linéarité de la courbe de variation de cette dernière en fonction de la fréquence.

Dans un premier temps, avec un stub court-circuité de longueur $l_1$, on amène la varicap dans une position telle que sa variation d'impédance donne une variation de phase $\Delta\phi_v(\Gamma)$ la plus grande possible. Puis à l'aide d'une ligne de longueur $l_2$ on s'arrange pour obtenir une variation pratiquement linéaire de l'admittance ramenée.

Ce circuit comportant une varicap en série entre deux éléments de ligne permet de linéariser la courbe admittance ramenée en parallèle en fonction de la fréquence et, contrairement au cas où la varicap est placée en série dans le réseau de rebouclage, la linéarisation n'entraîne pas une diminution de la pente de cette courbe, au contraire. Il présente toutefois deux inconvénients :
- la pente de la courbe admittance ramenée en parallèle en fonction de la fréquence étant augmentée, il faut pour réaliser l'adaptation entrée-sortie du transistor, allonger le rebouclage ce qui augmente l'encombrement.
- La valeur ponctuelle de l'impédance ramenée en parallèle est trop sensible aux longueurs $l_1$ et $l_2$ ce qui peut changer complètement l'adaptation.

Une solution consiste à augmenter la pente de wobulation. Mais d'une part celle-ci est déjà élevée, d'autre part la non-linéarité à compenser serait plus grande.

Une autre solution consiste à ajouter une deuxième varicap dans le circuit de wobulation parallèle.

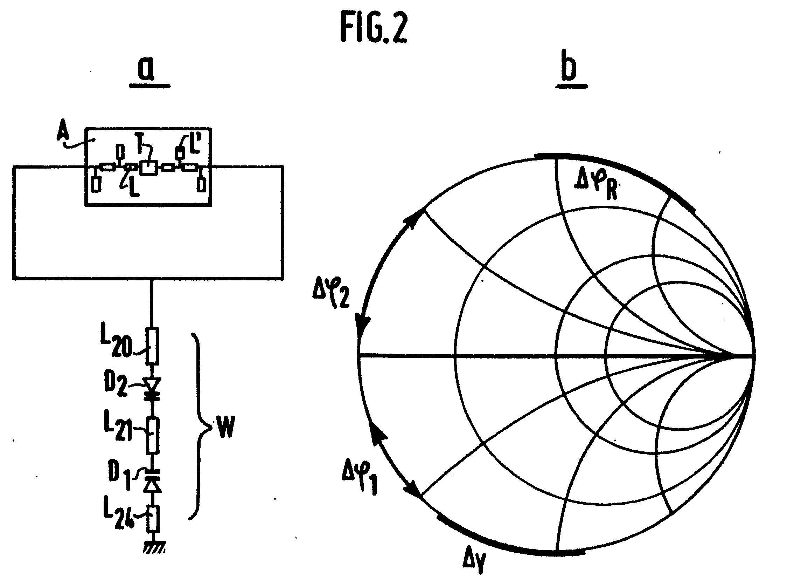

Le principe de fonctionnement de ce circuit est illustré sur la figure 2. La figure 2a est une représentation simplifiée de l'oscillateur de la figure 1 avec l'amplificateur hyperfréquence A rebouclé sur lui-même et comportant le transistor T avec ses impédances d'adaptation d'entrée et de sortie constituées de lignes L et de stubs L', et le circuit de wobulation w conforme à l'invention monté entre un point du réseau de rebouclage et la masse. La figure 2b montre les variations successives de la phase du coefficient de réflexion $\phi(\Gamma)$ portées sur l'abaque de Smith.

A l'aide de la ligne court-circuitée $L_{24}$ de longueur $l_1$, on amène la première varicap $D_1$ à donner une variation de phase maximale $\Delta\phi_1(\Gamma)$. La ligne $L_{21}$ de longueur $l_2$ permet à la deuxième varicap $D_2$ de fournir également une variation de phase $\Delta\phi_2(\Gamma)$ maximale. La troisième ligne $L_{20}$ de longueur $l_3$ ramène la variation de phase en $\Delta\phi_R$ et l'impédance du circuit de wobulation dans une zone telle que la variation $\Delta y$ de l'admittance totale est quasiment linéaire en fonction de la fréquence.

L'utilisation de deux varicaps n'augmente pas la non-linéarité à compenser mais augmente la variation de phase utile.

La pente de la courbe de variation de l'admittance ramenée en parallèle en fonction de la fréquence est plus faible que dans le cas à une seule varicap et la valeur ponctuelle de y est moins sensible aux longueurs $l_1$, $l_2$ et $l_3$.

Pour simplifier le raisonnement on ne s'est intéressé qu'aux longueurs $l_1$, $l_2$ et $l_3$ des lignes du circuit de modulation parallèle. Les impédances de ces lignes jouent également un rôle dans l'efficacité de la wobulation. Une étude plus approfondie permet de remarquer que l'impédance de la première ligne de longueur $l_1$ devra être la plus forte possible pour limiter la dispersion néfaste qu'elle entraîne, sa longueur étant ajustée en conséquence. Les lignes de longueur $l_2$ et $l_3$ auront quant à elles une impédance plus forte pour conserver au maximum la variation de phase favorable apportée par les varicaps.

Tel qu'il se présente, le circuit de modulation présente une admittance moyenne différente de zéro. Si l'on souhaite placer la wobulation en un point du rebouclage proche du point de circuit ouvert pour conserver la linéarisation, il faut ajouter en ce point un stub qui centre la variation d'admittance autour de zéro.

Etant donnée la puissance qui circule dans l'oscillateur, les varicaps ne peuvent être utilisées trop près d'une tension de polarisation nulle sous peine de détection : il faut tenir compte de la tension HF aux bornes des varicaps.

Pour pouvoir les utiliser à des tensions de polarisation faibles c'est-à-dire là où elles sont le plus efficaces, il est préférable de placer le circuit de wobulation entre la sortie couplée du coupleur et l'entrée du transistor, plutôt qu'entre la sortie du transistor et le coupleur.

D'autre part la première varicap subit une tension HF plus élevée que la seconde. Aussi si l'on souhaite utiliser les varicaps au mieux de leurs performances, on peut décaler les deux dents de scie du signal de commande des varicaps d'une valeur de tension constante.

En conclusion, la mise en parallèle du circuit de modulation se révèle plus efficace que la mise en série, aussi bien du point de vue bande de wobulation que du point de vue linéarité.

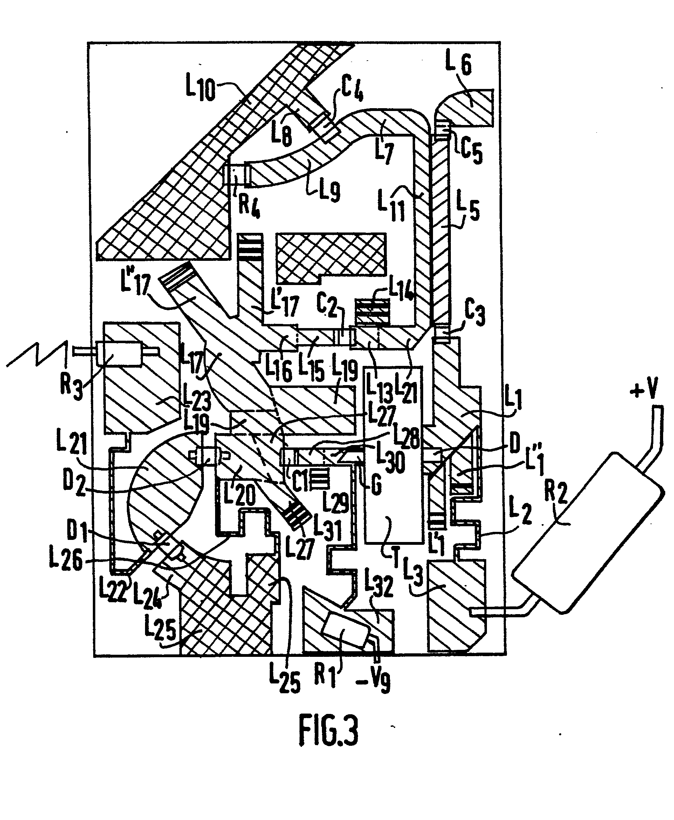

La figure 3 montre un exemple de réalisation de l'oscillateur.

Chaque ligne du schéma de la figure 1 représentée en traits hachurés dans un sens ou dans l'autre est réalisée à l'aide d'une couche conductrice de longueur et de largeur bien définies déposées par sérigraphie sur une face d'une plaquette isolante. L'autre face en communication avec la précédente par l'intermédiaire de trous percés dans la plaquette est recouverte d'une couche conductrice uniforme qui constitue le plan de masse. Cette technologie est connue sous l'appellation de "strip-line" ou "microstrip" dans la littérature anglo-américaine.

Les lignes et stubs tels que $L_9$, $L_{12}$, $L_{30}$, $L_1$, $L_4$, $L_6$, $L'_{17}$, $L''_{17}$ appartenant aux circuits d'adaptation d'entrée et de sortie du transistor ont une largeur relativement élevée par rapport à des lignes telles que $L_2$, $L_{22}$, $L_{26}$ et $L_{31}$ qui ont une longueur de $\lambda/4$ et présentent une forte impédance pour assurer les amenées de courant au circuit ou les mises à la masse. Les lignes $L_{11}$ et $L_5$ du coupleur sont formées d'éléments de même longueur, de largeur faible par rapport à ladite longueur et suffisamment rapprochés. Les plages du circuit réunies à la masse sont hachurées dans les deux sens. Les composants basse fréquence tels que les résistances d'alimentation $R_1$, $R_2$ et $R_3$ sont rapportés par soudures.

Le transistor à effet de champ T est un transistor AsGa à fort gain ($\simeq 10$ dB) ayant une puissance de sortie proche du watt.

L'encombrement de l'oscillateur est de 25 mm x 40 mm.

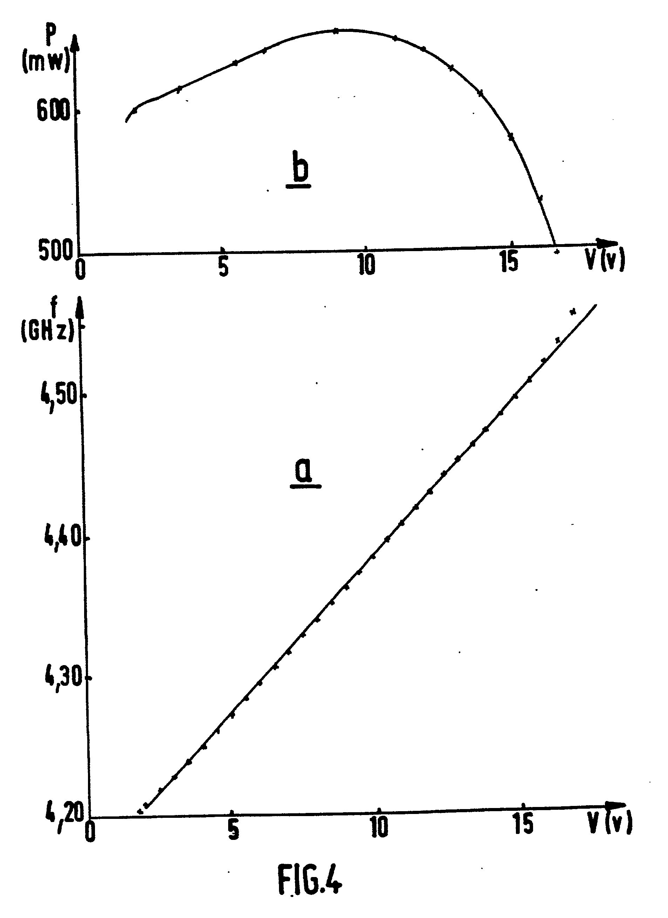

La figure 4a représente une caractéristique expérimentale de variation de la fréquence de sortie en fonction de la tension de commande des varicaps.

Autour d'une fréquence centrale de 4,35 GHz obtenue pour une tension de commande des varicaps de 8,5 V, l'examen de cette caractéristique met en évidence une bande de fréquence de 210 MHz wobulée linéairement à moins de 4 % et une autre bande de fréquence de 290 MHz wobulée linéairement à moins de 10 %, la linéarité étant évaluée selon sa définition la plus sévère comme le rapport des pentes maximale et minimale de la caractéristique dans la bande de fréquence considérée.

La simulation sur ordinateur prévoit une bande maximale de 400 MHz wobulée linéairement à moins de 10 %. En pratique 200 à 250 MHz semble être la limite raisonnable que l'on puisse atteindre, compte tenu de l'imprécision du calcul des adaptations du transistor et de la puissance de sortie désirée, avec un circuit comportant deux varicaps.

Il est certain qu'en utilisant un nombre de varicaps plus élevé et un transistor de faible puissance de sortie on pourra obtenir un oscillateur plus performant.

La figure 4b donnant la variation expérimentale de la puissance de sortie de l'oscillateur en fonction de la même tension de commande montre que la valeur moyenne de cette puissance est de l'ordre de 600 mW.

**Revendications**

1. Oscillateur hyperfréquence de puissance, modulé linéairement sur une grande plage de fréquence autour d'une fréquence centrale au moyen de deux diodes à capacité variable en fonction d'une tension de commande ($D_1$, $D_2$) et dont les cathodes sont reliées entre elles à travers un élément de ligne ($L_{21}$) sur lequel est appliqué ladite tension de commande, ledit oscillateur comportant un transistor (GDS) dont l'entrée est constituée par la base ou la grille (G) et la sortie par le drain ou l'émetteur (D) et dont l'adaptation à 50 Q de l'impédance sur cette entrée et sortie de transistor est constituée par des lignes calculées de façon à assurer un gain maximum à la fréquence centrale, caractérisé en ce que ledit transistor ayant un gain élevé et une forte puissance de sortie, l'oscillation est obtenue pour un mode de fonctionnement stable du transistor dans ladite plage de fréquence, au moyen d'un réseau de rebouclage renvoyant une partie du signal de sortie de l'oscillateur sur le signal d'entrée de ce dernier ($L_{11}$, $L_5$), lesdites diodes à capacité variable ($D_1$, $D_2$) étant intercalées en série entre trois éléments de ligne ($L_{24}$, $L_{21}$, $L_{20}$) dans un circuit de wobulation monté en parallèle sur ledit réseau de rebouclage, ledit élément de ligne reliant les cathodes entre elles ($L_{21}$) constituant l'un des trois éléments, les deux autres éléments ($L_{20}$, $L_{24}$) dont une extrémité est reliée à une anode de diode étant connectés respectivement par l'autre extrémité à un point du réseau de rebouclage situé sur le circuit d'adaptation de l'entrée (G) du transistor (GDS) et à la masse, lesdits éléments de ligne ($L_{24}$, $L_{21}$, $L_{20}$) du circuit de wobulation ayant des impédances élevées pour conserver au maximum la correction de phase introduite par les deux diodes à capacité variable ($D_1$, $D_2$).

2. Oscillateur selon la revendication 1, caractérisé en ce que ledit rebouclage est assuré à partir d'un coupleur constitué de deux lignes ($L_5$, $L_{11}$) situées à proximité l'une de l'autre à la sortie de l'oscillateur (SORTIE) dont une faible partie de la puissance est ainsi prélevée par rayonnement et renvoyée sur l'entrée (G) à travers ledit réseau de rebouclage comportant la ligne équivalente au coupleur et respectant la condition d'oscillation.

3. Oscillateur selon l'une des revendications 1 à 2, caractérisé en ce que ledit transistor à gain élevé et à forte puissance de sortie est un transistor à effet de champ (GDS) dont la source est à la masse et dont la grille (G) et le drain (D) sont respectivement lesdites électrodes d'entrée et de sortie.

## Claims

1. Microwave-frequency power oscillator modulated linearly over a wide frequency range around a central frequency by means of two variable capacitance diodes the capacitance of which may be varied in response to a control voltage ($D_1$, $D_2$) and whose cathodes are interconnected via a line element ($L_{21}$) to which this control voltage is applied, the oscillator comprising a transistor (GDS) whose input is constituted by the base or the gate (G) and whose output is constituted by the drain or the emitter (D) and of which the impedance matching to 50 Ohms at this transistor input and output is provided by computed lines in order to ensure a maximum gain at the central frequency, characterised in that for said transistor, which has a large gain and a considerable output power, the oscillation is obtained for a stable operating mode of the transistor in said frequency range, by means of a feedback network sending back part of the oscillator output signal to the latter's input signal ($L_{11}$, $L_5$), said variable capacitance diodes ($D_1$, $D_2$) being interconnected in series between three line elements ($L_{24}$, $L_{21}$, $L_{20}$) in a wobbulator circuit connected in shunt to the feedback network, said one line element ($L_{21}$) interconnecting the cathodes that together constitute one of the three line elements, the other two elements ($L_{20}$, $L_{24}$), of which one end is connected to a diode anode, being connected by the respective other ends to a point in the feedback network situated in the matching circuit of the input (G) of the transistor (GDS) and to earth, said line elements ($L_{24}$, $L_{21}$, $L_{20}$) of the wobbulator circuit having high impedances for maintaining the optimum phase correction introduced by the two variable capacitance diodes ($D_1$, $D_2$).

2. Oscillator as claimed in Claim 1, characterised in that said feedback is provided from a coupler consisting of two lines ($L_5$, $L_{11}$) located at the output of the oscillator (OUTPUT), a small part of the power of which is thus tapped by radiation and returned to the input (G) through said feedback network comprising the line equivalent to the coupler and meeting the oscillation condition.

3. Oscillator as claimed in one of the Claims 1 and 2, characterised in that said high-gain and high output power transistor is a field effect transistor (GDS) of which the source is earthed and the gate (G) and drain (D) are respectively said input and output electrodes.

## Patentansprüche

1. Hyperfrequenzleistungsgenerator, der in einem großen Frequenzgebiet um eine Zentralfrequenz linear moduliert ist, und zwar mittels zweier Dioden mit veränderlicher Kapazität abhängig von einer Steuerspannung ($D_1$, $D_2$), wobei die Kathoden der Dioden über ein Leitungselement ($L_{21}$) miteinander verbunden sind, wobei diesem Leitungselement die genannte Steuerspannung zugeführt wird, wobei der genannte Oszillator einen Transistor (GDS) aufweist, dessen Eingang durch die Basis oder das Gate (G) gebildet wird und dessen Ausgang durch die Drain oder den Emitter (D) und wobei die Anpassung an 50 Ohm der Impedanz an diesem Eingang und Ausgang des Transistors derart durch Rechnerleitungen gebildet wird, daß eine maximale Verstärkung bei der Zentralfrequenz erzielt wird, dadurch gekennzeichnet, daß der genannte Transistor eine erhöhte Verstärkung und eine hohe Ausgangsleistung aufweist, wobei die Schwingung erhalten wird für eine stabile Betriebsart des Transistors in dem genannten Frequenzgebiet, mittels eines Rückkopplungsnetzwerkes, das einen Teil des Ausgangssignals des Oszillators zu dem Eingangssignal desselben ($L_{11}$, $L_5$) zurückkoppelt, wobei die genannten Dioden mit veränderlicher Kapazität ($D_1$, $D_2$) in Reihe zwischen drei Leitungselementen ($L_{24}$, $L_{21}$, $L_{20}$) in einem Wobblerkreis liegen, der zu dem genannten Rückkopplungskreis parallelgeschaltet ist, wobei das genannte Leitungselement, das die Kathoden ($L_{21}$) miteinander verbindet, das eine der drei Elemente bildet, wobei die zwei anderen Elemente ($L_{20}$, $L_{24}$), von denen ein Ende mit einer Anode der Diode verbunden ist, über das andere Ende mit einem Punkt des Rückkopplungsnetzwerkes, der in dem Anpassungskreis des Eingangs (G) des Transistors (GDS) liegt, sowie mit Masse verbunden ist, wobei diese Leitungselemente ($L_{24}$, $L_{21}$, $L_{20}$) des Wobblerkreises hohe Impedanzen aufweisen um die durch die zwei Dioden mit veränderlicher Kapazität ($D_1$, $D_2$) eingeführte maximale Phasenkorrektur beizubehalten.

2. Oszillator nach Anspruch 1, dadurch gekennzeichnet, daß die genannte Rückkopplung von einer Koppelschaltung durchgeführt wird, die aus zwei Leitungen ($L_5$, $L_{11}$) besteht, die nahe beieinander am Ausgang des Oszillators (SORTIE) liegen, wobei ein geringer Teil der Leistung auf diese Weise durch Strahlung abgegriffen und über das genannte Rückkopplungsnetzwerk mit der gleichwertigen Leitung zur Koppelschaltung und den Schwingungszustand berücksichtigend zum Eingang (6) zurückgeführt wird.

3. Oszillator nach einem der Ansprüche 1 und 2, dadurch gekennzeichnet, daß der genannte Großverstärkungs- und Hochleistungstransistor ein Feldeffekttransistor (GDS) ist, dessen Source an Masse liegt und dessen Gate (G) und Drain (D) die genannte Eingangs- bzw. Ausgangselektrode bilden.

EP 0 203 663 B1

FIG.1

FIG.2

a

b

EP 0 203 663 B1

FIG.3

FIG.4